# EUROPEAN PATENT APPLICATION

(11) **EP 2 575 233 A1**
(43) Date of publication of application: **03.04.2013**
(21) Application number: 11183374.5
(22) Date of filing: 30.09.2011
(51) Int. Cl.: H02J 7/00, H02J 7/32, H01L 41/113

(54) **Charging system for a rechargable power source**

(71) Applicant: Research In Motion Limited, Waterloo, ON N2L 3W8 (CA)
(72) Inventor: Rich, David Gerard, West Bloomfield, MI 48322 (CA); Winger, Lyall Kenneth, Waterloo, Ontario N2L 3W8 (CA); Boucher, Antoine Gilles Joseph, Waterloo, Ontario N2L 3W8 (CA); Sutarwala, Taha Shabbir Husain, Waterloo, Ontario N2L 3W8 (CA)
(74) Representative: Moore, Barry

(57) **Abstract**

There is provided a power source system which includes a self-charging system. In one embodiment, the power source system is used to power portable devices and may include a power source such as a set of rechargeable batteries or a battery pack. The power source system comprises a self-charging system which includes an energy harvester operatively connected to a vibrational energy source such as a plurality of piezoelectric elements (piezos). The piezos preferably include a plurality of cantilevers which are composed of a piezoelectric material which may be the same or may be different from the substrate material of the piezos.

## Description

### FIELD OF THE DISCLOSURE

The present disclosure relates generally to power sources. More particularly, the present disclosure relates to a charging system for a rechargeable power source.

### BACKGROUND OF THE DISCLOSURE

In recent years, the use of portable electronic devices has increased. Some of these portable electronic devices may be handheld, that is, sized and shaped to be held or carried in a human hand. These portable devices, such as portable computers (including tablet computers and laptop computers), mobile communication devices (such as cellular phones and smart phones), mobile communication device accessories, remote controls, electronic navigation devices (such as Global Positioning System devices) or portable DVD players, are typically powered by batteries that may be regularly changed or recharged. The re-charging of batteries is typically via a wired connection between the portable device and a charging apparatus, such as a wall socket or a battery charger. Alternatively, the battery may be removed from the portable device for re-charging.

However, if the battery is to be charged and the user is not in the vicinity of a charging apparatus, the portable device may be shut down to conserve power, or the device may be used until the battery is drained. Later, the user may be able to connect the portable device with a charging apparatus. This may be very inconvenient to a user especially if an emergency situation arises. The complete draining of a battery also affects the efficiency or lifespan of the battery.

### SUMMARY

In one aspect, there is provided a power source system for a portable device comprising a charging system including an energy harvester and a set of vibrational energy sources connected to the energy harvester and a power source operatively connected with the charging system.

In another aspect, there is provided a power source system for a portable device comprising a self-charging system including an energy harvester operatively connected to a set of piezoelectric elements wherein at least one piezoelectric element has its bending plane facing a first direction, at least another of the piezoelectric elements has its bending plane facing a second direction, and at least one of the piezoelectric elements has its bending plane facing a third direction, whereby the first, second and third directions are non-parallel and a power source operatively connected with the self-charging system.

### BRIEF DESCRIPTION OF THE DRAWINGS

Embodiments will now be described, by way of example only, with reference to the attached Figures, wherein:
Figure 1 is a schematic drawing of an illustrative portable electronic device;
Figure 2 illustrates a power source system with an integrated vibrational energy source, such as a piezoelectric element;
Figure 3 illustrates an alternative embodiment of an integrated piezoelectric power source system;
Figure 4 illustrates in more detail a power source system with integrated piezoelectric charger;
Figure 5 is a flow chart outlining a method of operation; and
Figure 6 illustrates a power source system integrated in an accessory for a portable device.

### DETAILED DESCRIPTION

According to the disclosure, there is provided a power source system which includes a self-charging system. ln one embodiment, the power source system is used to power portable devices and may include a power source such as a set of rechargeable batteries or a battery pack. The power source system comprises a self-charging system which includes an energy harvester operatively connected to a vibrational energy source such as a plurality of piezoelectric elements (piezos). Generally speaking, vibrational energy sources convert mechanical energy or motion—often in the form of back-and-forth movement or vibration—into electrical energy that can be used or stored. For simplicity, and because the miniature nature of piezos make them well-suited for portable electronic devices in which concerns such as size and weight are important, the vibrational energy sources may be referred to as piezos. In one embodiment, the piezos include a plurality of cantilevers which are composed of a piezoelectric material which may be the same or may be different from the substrate material of the piezos. If the power source is a hybrid battery, comprising at least one rechargeable battery and at least one other type of power source (such as fuel cell system or solar cell or energy storage device), the self-charging system may be integrated within the hybrid battery.

In other words, the power source system includes an apparatus which can generate power so that the power source within the power source system may be independently re-charged. Colloquially, the power source within the power source system may be re-charged without the necessity of connection to a recharging apparatus (although the power source system may also work in concert with a recharging apparatus). This power may be generated via the vibrational energy source and then harvested, or stored, for later use. Alternatively, the power generated by the vibrational energy source may be used to directly power components or supplement the power supplied to these components within the portable device.

In one embodiment, the vibrational energy source may comprise at least three piezos. In one possible setup, the piezos may lie in one or more axes and may be connected to an apparatus for storing or harvesting the generated power or to the power source to re-charge the power source.

Some of the piezos may have a larger width as compared to thickness. By using piezos with this structure, the bending plane, i.e. a plane within the piezo which has a tendency to bend more easily than other planes may be created or designed.

In the embodiment of the system having at least three piezos, the set of at least three piezos may be mounted such that their bending planes are each facing different directions whereby the directions of the three bending planes are non-parallel. In this manner, vibration of the device or accessory in any direction will allow power to be generated.

Alternatively, environmental energy or environmental vibrations experienced by the portable device may cause power to be generated by the self-charging system for charging the power source. By integrating piezos, or a harvesting apparatus, within the power source system to harvest mechanical vibration energy, the power source system may be able to store power which may be generated during various activities, such as the portable device being shaken due to movement by the user, or the portable device being shaken when resting in a cup holder within a vehicle when the vehicle is in motion.

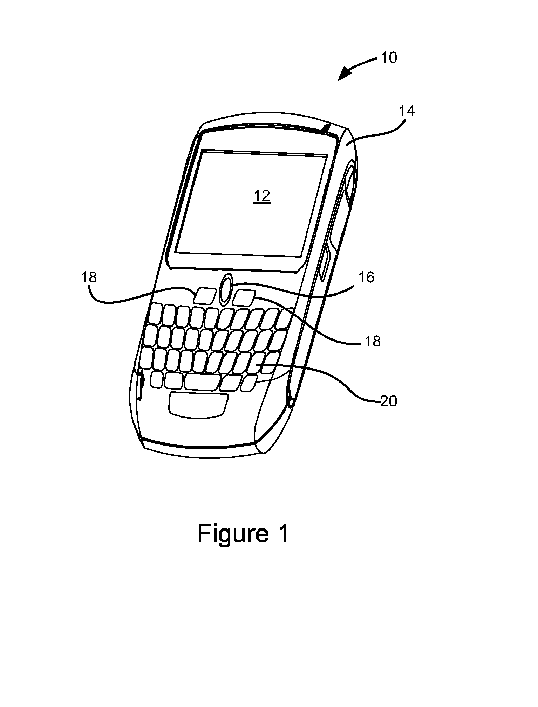

Figure 1 illustrates a perspective view of an illustrative portable electronic device 10 such as a mobile communication device (e.g., a smart phone). The portable electronic device 10 has a body 14, which includes a display screen 12, a keyboard/keypad 20, a set of buttons 18 and a trackball 16. The trackball 16 may also be a joystick, scroll wheel, roller wheel, trackball or touchpad or the like, or another button. The portable electronic device 10 includes other parts which are not shown or described in this figure. The portable electronic device 10 in Figure 1 is one example of a handheld device that may be sized such that it fits within the palm of a hand.

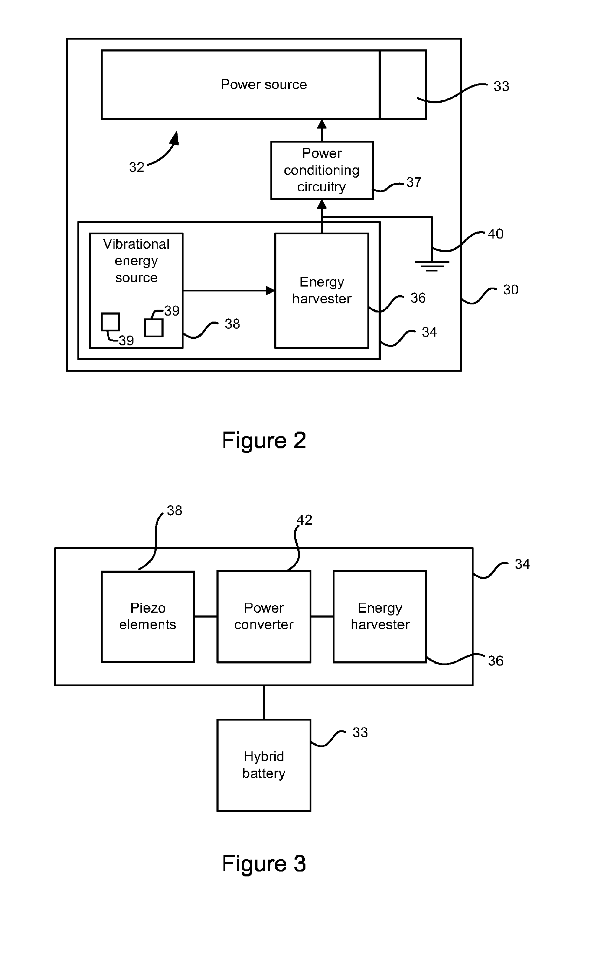

Figure 2 illustrates a power source system which may be inserted into the portable device for powering the device. In one embodiment, the power source system 30 includes a power source 32 which may be a battery pack having a hybrid battery 33. Alternatively, the power source 32 may be a rechargeable battery. A battery may include one or more cells that store energy chemically. The concept described herein is not limited to any particular manner of energy storage or battery chemistry.

The power source system 30 further includes a charging, or self-charging, system 34 that includes an energy harvester 36 and a vibrational energy source 38. In order to enable the harvester 36 to be compatible with the power source 32, extra conditioning may be required or may be beneficial, which may be performed by power conditioning circuitry 37. This conditioning may include, but not limited to, limiting the amount of energy transferred to the battery 33 from the harvester 36 or to provide a substantially constant flow of energy or a substantially constant voltage or current to the battery 33 from the harvester 36.

The energy harvester 36 stores energy which is generated by the vibrational energy sources 38 such as piezoelectric elements, or piezos 39. Piezoelectricity relates to the charge which accumulates in certain solid materials in response to applied mechanical strain or vibrations. Therefore, when the device is vibrated or shaken, the piezos may generate electricity, or power, for storage within the energy harvester 36 or for being applied directly to the battery 33 for re-charging of the battery 33. If the vibrational energy sources 38 are piezos 39, the piezos 39 may include at least one cantilever which is made from a piezoelectric or substrate material which may be the same as or different from the material of the piezo 39.

In an alternative embodiment, the energy harvester 36 may be integrated within the hybrid battery 33.

In another embodiment, the portable device may include apparatus for sensing the level of charge remaining in the battery 33 so that the battery 33 remains charged above a threshold value. The system may be set up whereby if the charge level is above a certain threshold, the power generated by the piezos 39 may be stored in the energy harvester 36. Alternatively, a component for diverting the power generated by the piezos 39 may divert or ground the energy produced by the piezo 39 when the battery 33 is charged above the threshold value and when the harvester 36 is full.

In another embodiment, as shown in Figure 3, the charging system 34 includes a set of vibrational energy sources, seen as piezos 39, an energy harvester 36, and a power converter 42. In this embodiment, the charging system 34 is connected to a hybrid battery 33. The power converter 42 facilitates power conversions between the power generated by the piezos 39 and the harvester 36 or the harvester 36 and the battery 33 or a combination of both. The power converter 42 may be a DC-to-DC or an AC-to-DC converter. In one embodiment, the power converter 42 may convert the direct current from the harvester 36 to a voltage that would be accepted by the battery 33.

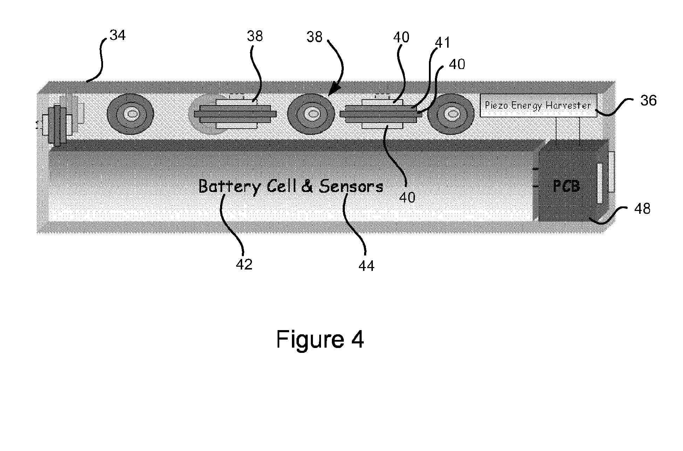

Figure 4 is a schematic diagram of a charging system for a power source system. In this embodiment, the charging system 34 is an independent system but is connected to a power source 42, such as a battery, and device components, such as sensors 44. The charging system 34 includes a set of vibrational energy sources 38, seen as a plurality of piezos 39 which are connected to an energy harvester 36. As shown the piezos are oriented in different axes so that any movement of the device may be captured by the charging system to generate power via the vibration energy sources 38. The axes may be orthogonal (that is, substantially at right angles) to one another.

Although shown in two dimensions, the piezos may be installed on any or all axes to increase the opportunity for energy harvesting from acceleration or vibration in any direction.

Individual cantilevers 41 within each of the piezos 39 may have various resonant frequencies or resonant frequency spectrums or the individual cantilevers may have multiple resonant frequencies or frequency spectra. Based on the characteristics of the cantilevers, such as thickness, width, length or material properties, these resonant frequencies may be set up before the charging system is integrated. In this manner, the charging system 34 may be capable of generating power at various frequencies of vibration. Other external tuning modifiers such as pre-load or tension may also be set. One potential consequence of having elements that respond (or that respond more efficiently) to particular frequencies is that the vibrational energy sources may be tuned to respond to expected motions of the device (such as being shaken by a user or being shaken by the operation of a motor vehicle).

With some piezoelectric materials, if the properties of the resonant frequency are changed, the charging system 34 may generate power at a higher number of frequencies. One advantage of the present disclosure is the use of piezoelectric material as the vibrational energy sources.

In a preferred embodiment, there may be at least three piezoelectric elements 39 mounted to, or operatively engaged with the energy harvester 36. One of the piezos is aligned with its bending plane facing in one direction, a second piezo is aligned with its bending plane facing in a second direction while a third piezo is aligned with its bending plane facing a third direction where the first, second and third directions are preferably non-parallel. In one embodiment, the bending planes of the piezos 39 may be in an orthogonal relationship. In this alignment, the piezos may be set so that the vibration or movement of the portable device in any orientation may allow power to be generated and harvested. Further piezos 39 could be added in other orientations, but preferable movement in at least three axes would be covered.

Further, as shown in figure 4, the piezoelectric elements 39 may be of various resonant frequencies and may be situated in layers 40 and be of different sizes and shapes. Although the piezos in Figure 4 are shown as being circular, other shapes may be contemplated. This structure allows the piezos to be tuned to known environment resonant frequencies. In order to implement this embodiment, the charging system 34 further includes a frequency converter to increase the number of situations where energy or power may be harvested. The piezos may also be able to co-fire, allowing for further energy harvesting.

Between the piezoelectric elements 39, substrate material 40a and 40b may be layered. In one embodiment, the substrate material is typically silver. In the embodiment with three piezos 39 may form a set in which each piezoelectric element may be oriented such that its bending plane is preferably orthogonal to the bending planes of the other piezos 39.

A charging system has at least one set of piezoelectric elements and may have a plurality of piezos depending on the power requirements of and the space available within the device.

As further shown in Figure 4, the set of piezoelectric elements with their different substrate material layers may all be connected to the energy harvester 36 to store or deliver the power generated. The energy harvester 36 may be further connected to a printed circuit board 48 that may route the energy to the device components such as, but not limited to, the battery 42 or sensors 44 or both. Alternatively, the energy harvester 36 may either be directly connected with, or integrated into the battery.

In a further embodiment, the charging system 34 may have an unlimited number of piezoelectric elements, limited only by the space available in the portable device to accommodate the power source and the charging system. In embodiments where space may be a limitation, thin layers of the piezoelectric elements may allow for greater efficiency in generating power from vibrational motion. As the thinner piezoelectric elements may not require multiple substrate layers, a higher number of piezos may be integrated within the battery pack. When one piezoelectric element is in operation, it may have a reaction on the other piezoelectric elements it is connected or near to, causing them to begin operating as well which will cause power to be generated.

As thinner, smaller piezoelectric elements may have greater deflections than thicker, or larger ones, thinner piezoelectric elements may allow for more power to be generated. Typically, the thickness of a piezoelectric material is inversely related to the power it generates such that if the thickness of a substrate layer can be reduced in half, it may be able to generate twice the power assuming the same vibrational motion.

In another embodiment, in order to generate more power per vibrational movement, the piezoelectric elements may be mechanically connected and may employ the use of mechanical connectors such as gears, levers, springs, and the like, which would redirect vibrational energy to the best axis for power generation or move at least one piezoelectric element to another axis which would allow for more power to be generated.

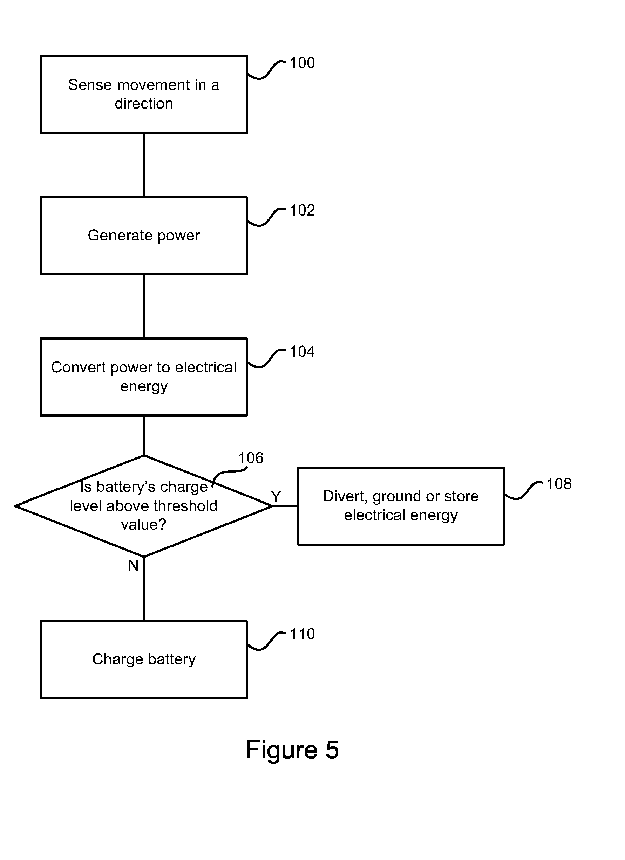

Figure 5 illustrates a method of operation according to one embodiment of the disclosure. When the portable device experiences movement in any direction such as small environmental vibrations (where the portable device is in a cup holder in a car and the car is in motion or the portable device is a user's pocket while the user is walking) or larger vibrations such as being shaken by a user, the piezoelectric elements capture this vibrational motion 102 to generate power and which may then be converted to electrical energy 104. Once the electrical energy has been generated, the charging system determines the power or current level of the battery 106. If the level is above a threshold value, the generated electrical energy may be diverted, grounded or stored in an energy harvester 108. If the charge level is less than a threshold value, the generated electrical energy is used to charge the power source, or battery 110.

Alternatively, the generated energy may be stored before the battery or current charge level is checked or this may be done concurrently. Different setups are contemplated and possible.

By integrating the charging system within other portable devices, these devices could also be charged through vibrations. As an example, other portable devices such as an MP3 player could include such a system. The vibrations from operation of a vehicle would activate the charging system containing piezoelectric elements allowing the power source of the device to be continually charged. By using the vibrational energy created by the car's engine, the road, the wind, or other sources, electrical energy can be harvested, stored and used by portable devices in a variety of locations without the need for hard wiring the device.

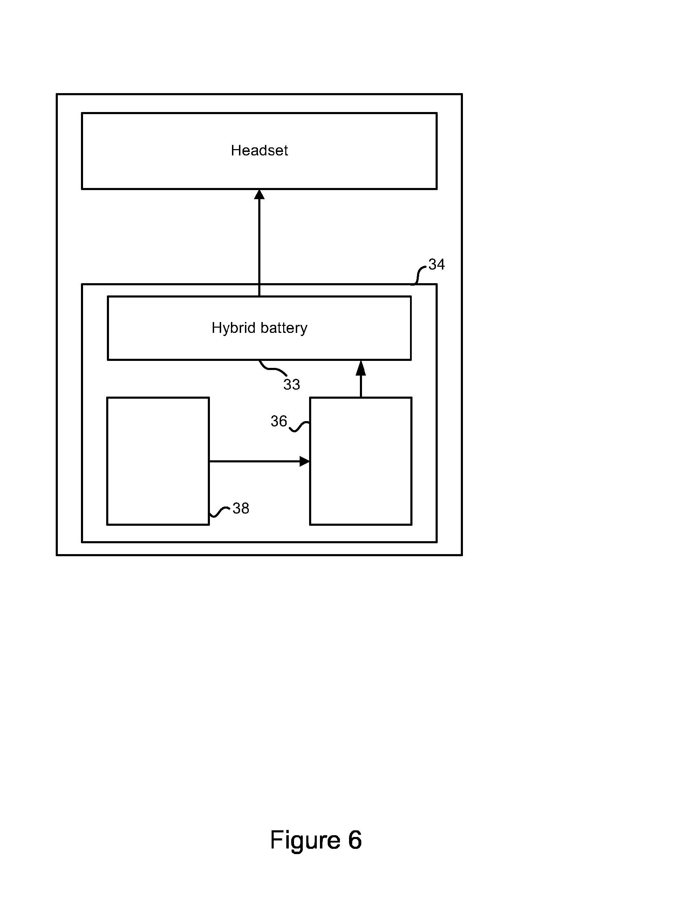

The power source system is not limited to particular portable electronic devices but may also apply to (for example) portable device accessories, for example a Bluetooth headset as shown in Figure 6. In another embodiment, the piezos may be connected in any combination of series or parallel configurations to deliver voltage/current.

In another embodiment, a charging accessory including a vibrational energy source is contemplated. In order to generate power, or electrical energy, within the charging accessory, the accessory may be shaken, or vibrated, so that power may be produced by the vibration energy source or sources, such as piezos. Once it is powered up, the charging accessory may be able to serve as a power source for re-charging other power sources.

Implementation of one or more embodiments may realize one or more advantages, some of which have been mentioned already. The concepts described herein are flexibly adaptable to a variety of devices. Some embodiments may supplant the use of a recharger, while others may supplement and work in concert with a recharging apparatus. Convenience to a user may be improved, and a user may have the capability of generating electrical energy in emergency situations or where a charging apparatus is not available. Recharging can be adapted to a user's particular style or preferences. Many of the embodiments can be implemented on a relatively small scale, taking up little space and weight.

The above-described embodiments are intended to be examples only. Alterations, modifications and variations can be effected to the particular embodiments by those of skill in the art without departing from the scope of this application.

## Claims

1. A power source system for a portable device comprising:
a charging system including:
an energy harvester, and
a set of vibrational energy sources connected to the energy harvester; and
a power source operatively connected with the charging system.

2. The power source system as claimed in claim 1 wherein the vibrational energy sources are piezoelectric elements.

3. The power source system as claimed in claim 2 wherein the set of piezoelectric elements comprise at least three piezoelectric elements wherein:
at least one piezoelectric element has its bending plane facing a first direction;
at least one piezoelectric element has its bending plane facing a second direction; and
at least one piezoelectric element has its bending plane facing a third direction;
the first, second and third directions being orthogonal to each other.

4. The power source system as claimed in any preceding claim wherein the vibrational energy sources including at least one cantilever.

5. The power source system as claimed in claim 4 wherein the at least one cantilever comprises one of:
piezoelectric material;
substrate and piezoelectric material.

6. The power source system as claimed in any preceding claim wherein the power source is a hybrid battery.

7. The power source system as claimed in any preceding claim wherein the charging system further comprises at least one of:
a power converter;
a diverter.

8. The power source system as claimed in any preceding claim wherein the system is integrated within the portable device.

9. The power source system as claimed in claim 8 wherein the portable device is connected with a vibration based accessory.

10. A power source system for a portable device comprising:
a self-charging system including an energy harvester operatively connected to a set of piezoelectric elements wherein:
at least one piezoelectric element has its bending plane facing a first
direction,
at least another of the piezoelectric elements has its bending plane facing a second direction, and at least one of the piezoelectric elements has its bending plane facing a third direction;
whereby the first, second and third directions are non-parallel; and
a power source operatively connected with the self-charging system.

11. The power source system as claimed in claim 10 wherein the first, second and third directions are orthogonal to each other.

12. The power source system as claimed in claim 10 or 11 wherein at least one piezoelectric element in the set of piezoelectric elements includes a cantilever.

13. The power source system as claimed in claim 12 wherein the cantilever is made from piezoelectric material.

14. The power source system as claimed in claim 13 wherein the cantilever is made from substrate and piezoelectric material.

15. The power source system as claimed in any one of claims 10 to 14 wherein the self-charging system further comprises:
a power converter; and
a diverter.

## Amended claims

### Amended claims in accordance with Rule 137(2) EPC.

**1.** A power source system (30) for a portable device (10) comprising:
a charging system (34) including:
an energy harvester (36), and
a set of vibrational energy sources (38) connected to the energy harvester (36);
a power source (33) operatively connected with the charging system (34); and
a component for diverting power generated from the set of vibrational energy sources (39).

**2.** The power source system (30) as claimed in claim 1 wherein the vibrational energy sources (38) are piezoelectric elements (39).

**3.** The power source system (30) as claimed in claim 2 wherein the set of piezoelectric elements (39) comprise at least three piezoelectric elements wherein:
at least one piezoelectric element has its bending plane facing a first direction;
at least one piezoelectric element has its bending plane facing a second direction; and
at least one piezoelectric element has its bending plane facing a third direction;
the first, second and third directions being orthogonal to each other.

**4.** The power source system (30) as claimed in any preceding claim wherein the vibrational energy sources (38) including at least one cantilever (41).

**5.** The power source system (30) as claimed in claim 4 wherein the at least one cantilever (41) comprises one of:
piezoelectric material;
substrate (40) and piezoelectric material.

**6.** The power source system (30) as claimed in any preceding claim wherein the power source is a hybrid battery (33).

**7.** The power source system (33) as claimed in any preceding claim wherein the charging system (34) further comprises a power converter (42).

**8.** The power source system (30) as claimed in any preceding claim wherein the system is integrated within the portable device (10).

**9.** The power source system (30) as claimed in claim 8 wherein the portable device (10) is connected with a charging accessory including a vibrational energy source.

**10.** The power source system (30) as claimed in claim 2 wherein the charging system is a self-charging system (34) and wherein the piezoelectric elements (39) comprise:
at least one piezoelectric element having a bending plane facing a first direction;
at least one other piezoelectric element having a bending plane facing a second direction, and
at least one other piezoelectric element having a bending plane facing a third direction;
whereby the first, second and third directions are non-parallel.

**11.** The power source system (30) as claimed in claim 10 wherein the first, second and third directions are orthogonal to each other.

**12.** The power source system (30) as claimed in claim 10 or 11 wherein at least one piezoelectric element (39) in the set of piezoelectric elements includes a cantilever (41).

**13.** The power source system (30) as claimed in claim 12 wherein the cantilever (41) is made from piezoelectric material.

**14.** The power source system (30) as claimed in claim 13 wherein the cantilever (41) is made from substrate (40) and piezoelectric material.

**15.** The power source system as claimed in any preceding claim, wherein the component for diverting power operationally diverts the energy produced by the set of vibrational energy sources (39) when the power source (33) is charged above a threshold value and when the energy harvester (36) is full.
